# EUROPÄISCHE PATENTANMELDUNG

(11) **EP 0 564 876 A1**
(43) Veröffentlichungstag der Anmeldung: **13.10.1993**
(21) Anmeldenummer: 93104571.0
(22) Anmeldetag: 19.03.1993
(51) Int. Cl.: H05K 5/06, H01H 9/04, C09J 5/06

(54) **Verfahren zur Abdichtung eines Gehäuses zur Aufnahme von elektrischen, elektronischen oder elektromechanischen Bauteilen.**

(30) Priorität: 10.04.1992 DE 4212068
(71) Anmelder: Hella KG Hueck & Co., D-59552 Lippstadt (DE)
(72) Erfinder: Bolzenius, Rainer, W-4788 Warstein (DE); Körner, André, W-4780 Lippstadt (DE)

(57) **Zusammenfassung**

Beschrieben wird ein Gerätegehäuse, welches eine Grundplatte aus einem Heißklebermaterial aufweist, sowie das sehr einfache und kostengünstige Verfahren zum Abdichten eines solchen Gehäuses mittels partiellem Aufschmelzen der Grundplatte durch eine Wärmequelle.

## Beschreibung

Die Erfindung betrifft ein Gehäuse zur Aufnahme von elektrischen, elektronischen oder elektromechanischen Bauteilen, insbesondere Relaisgehäuse, bestehend aus einer Grundplatte, durch welche mehrere elektrische Anschlußstifte hindurchgeführt sind und einer Gehäusekappe, deren Öffnungsränder mit einem umlaufenden Rand der Grundplatte verbunden ist.

Solche Gehäuse sollen nach dem Zusammenbau zumindest flüssigkeitsdicht sein, um die in das Gehäuse eingebauten Bauteile insbesondere vor dem Einfluß von Feuchtigkeit zu schützen.

Dies gilt insbesondere dann, wenn die aus dem Gehäuse ragenden Anschlußstifte mit einer Leiterplatte verlötet werden sollen, da Leiterplatten im allgemeinen vor dem Lötvorgang mittels Flußmittel behandelt werden und nach dem Lötvorgang gewaschen und/oder lackiert, insbesondere tauchlackiert werden.

Das mit der Leiterplatte verbundene Gehäuse muß daher gegen das Eindringen von Lack- bzw. Waschmedien ausreichend abgedichtet sein.

Als besonderes Beispiel hierfür seien in Gehäuse eingefaßte Leiterplattenrelais genannt, bei denen ein Eindringen von Verunreinigungen die Qualität der Kontakte oder die Beweglichkeit der Schaltglieder beeinträchtigen kann. Um Leiterplattenrelais abzudichten, ist es allgemein bekannt, die Relaisgehäusekappe mit einer Grundplatte zu verkleben oder zu vergießen.

Durch diesen zusätzlichen Arbeitsschritt, zu dem als zusätzlicher Werkstoff das Klebe- bzw. Vergußmittel benötigt wird, verkompliziert und verteuert sich der Fertigungsprozeß. Hinzu kommt, daß die dünnflüssigen Klebematerialien, die die Verbindung in den schmalen Fügespalten, zwischen Gehäusekappe und Grundplatte herstellen sollen, oft selbst Probleme verursachen, da sie in das Innere des Gehäuses eindringen und Schäden an den Bauteilen verursachen.

Vergußwerkstoffe wiederum benötigen oft erhebliche Aushärtzeiten und verzögern und verteuern so die Produktion.

Aus der DE-PS 34 06 256 ist ein Verfahren zum Abdichten von elektromechanischen Bauelementen bekannt. Hierbei wird einerseits vorgeschlagen, eine auf die abzudichtenden Öffnungen aufgebrachte rahmenförmige Dichtmasse mittels eines Laserstrahls aufzuschmelzen, so daß die Dichtmasse von selbst in abzudichtende Öffnungen fließt.

Weiterhin soll auch ein Abdichten des Gehäuses durch Aufschmelzen des Gehäusematerials selbst, mittels eines Laserstrahls möglich sein, so daß hier das Gehäusematerial gleichzeitig als Dichtmasse fungiert.

Das vorgeschlagene Verfahren dient dabei zum Abdichten sowohl des Verbindungsbereichs zwischen Grundplatte und Gehäusekappe als auch der Bereiche um die Kontaktstifte.

Die zur Ausführung dieses Verfahrens notwendige Vorrichtung ist unverhältnismäßig aufwendig und teuer. So wird ein kostenaufwendiger Lasergenerator benötigt, sowie auch eine ebenfalls relativ aufwendige Vorrichtung zur Steuerung des Laserstrahls, die beispielsweise aus einem Rechner und einer durch den Rechner gesteuerten Optik besteht.

Im Hinblick auf hohe Produktionszahlen ist es besonders nachteilig, daß eine solche kostenaufwendige Vorrichtung nicht mehrere Relais gleichzeitig abdichten kann, da hierzu zumindest eine weitere Vorrichtung zur Strahlsteuerung benötigt wird, was den Aufwand noch weiter erhöht.

Aufgabe der Erfindung ist es daher, ein Gehäuse zu schaffen, das besonders einfach und kostengünstig aufgebaut ist und auf besonders einfache Weise zumindest gegen das Eindringen von Flüssigkeit abgedichtet werden kann, sowie ein Verfahren zur Abdichtung eines solchen Gehäuses anzugeben.

Diese Aufgabe wird anhand der in den Ansprüchen 1 und 5 genannten Merkmale gelöst.

Das erfindungsgemäße Gehäuse weist dabei eine Grundplatte aus einem Schmelzklebermaterial auf. Solche handelsüblichen Schmelzkleber sind thermoplastische Kunststoffe, insbesondere auf Polyamid-Basis mit ausgeprägten, adhäsiven Eigenschaften im geschmolzenen Zustand und vorzugsweise gummielastischen Eigenschaften im erstarrten Zustand.

Die Verwendung eines solchen Schmelzkleberwerkstoffes als Grundplattenmaterial bringt dabei gleich mehrere Vorteile mit sich:
- Der Schmelzkleberwerkstoff kann auf einfache Weise bearbeitet werden. So kann die Grundplatte leicht aus dem Schmelzkleberwerkstoff gegossen, spritzgegossen oder aus Band- oder Folienmaterial ausgestanzt werden. Materialreste, die bei diesen Arbeitsgängen anfallen, können dabei leicht aufgearbeitet werden, so daß praktisch kein Abfall entsteht.
- Ein paßgenaues Zusammenfügen der Grundplatte, der Gehäusekappe und der Kontaktstifte ist aufgrund der gummielastischen Eigenschaften des Schmelzkleberwerkstoffs leicht möglich. Von besonderem Vorteil ist, daß beim Zusammenfügen kein relativ großvolumiger Fügespalt entsteht, der mit einer relativ großen Menge an Abdichtungsmaterial aufgefüllt werden müßte und wobei ein Eindringen des Abdichtungsmaterials durch das Gehäuseinnere nur schwer zu verhindern ist. Statt dessen bildet sich zwischen der Grundplatte und der Gehäusekappe ein sehr enger Fügespalt aus, der leicht auf die weiter unten beschriebene Weise abgedichtet werden kann.
- Je nach Einsatzzweck des Gehäuses können sehr niedrigschmelzende Schmelzkleberwerkstoffe verwendet werden, so daß die zum Aufschmelzen der Grundplattenränder erforderliche Energiedichte relativ gering sein kann. Durch die Verwendung einer Grundplatte aus Schmelzkleberwerkstoff kann somit auf die Anwendung eines Lasers zum Aufschmelzen des Grundplattenmaterials verzichtet werden, so daß auch sehr einfache und kostengunstige Wärme- (Strahlungs-)quellen, wie Infrarot-, Halogenstrahler, Heizelemente (Heißstempel) oder Vorrichtungen zur Erzeugung von Heißluft Verwendung finden können.
- Den, mit der in der DE-PS 34 06 256 beschriebenen Vorrichtung, mit hohem Aufwand erzielten Vorteil, daß eine räumlich sehr gezielte Temperaturzufuhr auf bestimmte Gehäusebereiche möglich ist, während wiederum die Temperaturbelastung anderer Gehäusebereiche sehr gering ist, ist auch bei dem erfindungsgemäßen Verfahren und mit weitaus geringerem Aufwand zu erzielen, indem nicht zu erwärmende Flächen mittels Masken vorzugsweise mittels solcher Masken, die die Wärmestrahlung gut reflektieren, beispielsweise solche aus Aluminium, abgedeckt werden.
- Die mechanischen Eigenschaften der Grundplatte aus Schmelzkleberwerkstoff können leicht durch Zugabe von geeigneten Füllstoffen, wie z. B. Glasfasern, Glasfasergewebe oder Glasfaservlies positiv beeinflußt werden. Insbesondere kann die mechanische Festigkeit erhöht werden, ohne daß die übrigen gewünschten Heißklebereigenschaften negativ beeinflußt werden.

Das in der Zeichnung skizzierte Ausführungsbeispiel veranschaulicht den Aufbau des erfindungsgemäßen Gehäuses und des erfindungsgemäßen Verfahrens zu dessen Abdichtung.

Die Figur 1 zeigt dabei den Aufbau eines erfindungsgemäßen Gehäuses am Beispiel eines Relaisgehäuses.

Figur 2 zeigt einen Schnitt durch ein zu einer Grundplatte gehörendes Druckausgleichselement.

Figur 3 veranschaulicht das Prinzip des erfindungsgemäßen Verfahrens zur Abdichtung des Gehäuses.

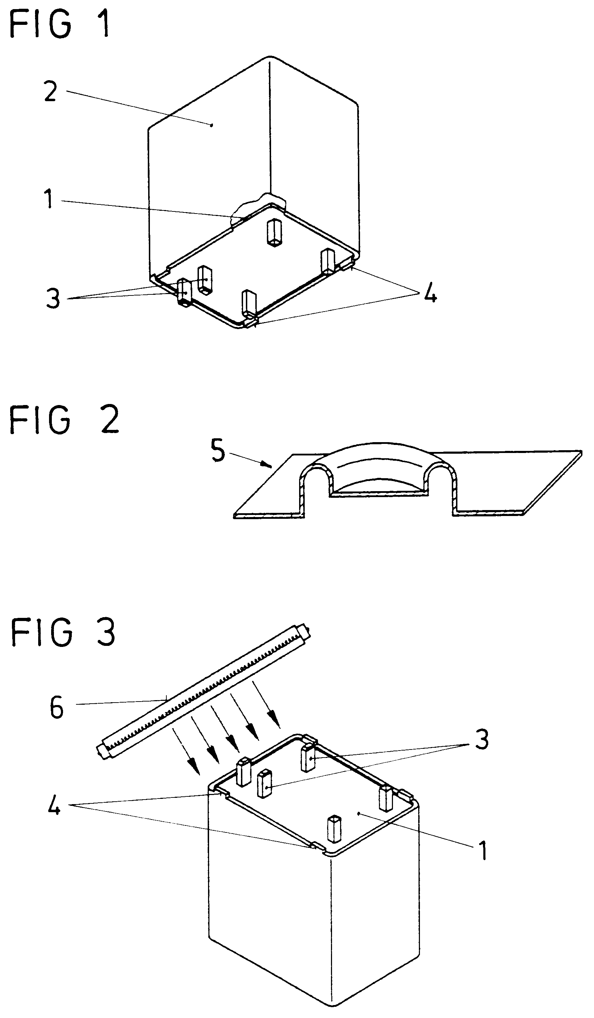

Die Figur 1 zeigt schematisch den erfindungsgemäßen Aufbau eines Relaisgehäuses.

Eine Grundplatte (1) aus einem Schmelzkleberwerkstoff liegt mit ihrem Rand an der Innenwandung der Gehäusekappe (2) umlaufend an.

In dem in der Figur 1 gezeigten Ausführungsbeispiel umfaßt die Gehäusekappe (2) die Grundplatte (1), dadurch können am Rand der offenen Seite in der Gehäusekappe (2) einige Böckchen (4) als Abstandshalter angeformt sein, welche beim Aufsetzen des Gehäuses auf eine nicht dargestellte Leiterplatte zwischen der Leiterplatte und der Grundplatte (1) einen Zwischenraum schafft. Das noch zu beschreibende Abdichtverfahren ist aber genauso gut durchführbar, wenn die Grundplatte (1) auf der stirnseitigen Umrandung der Gehäuseöffnung (2) aufliegt.

In die Grundplatte (1) sind einige Anschlußstifte (3) eingebracht. Die Durchbrüche zur Aufnahme der Anschlußstifte (3) in der Grundplatte (1) weisen vorteilhafterweise gegenüber den Anschlußstiften (3) Untermaß auf. Ein Einpressen der Anschlußstifte (3) ist dabei aufgrund der gummielastischen Eigenschaften des Grundplattenmaterials leicht möglich.

Die Figur 2 zeigt einen Schnitt durch ein Druckausgleichselement (5) (in der Figur 1 nicht dargestellt). Ein solches Druckausgleichselement (5) stellt eine zusätzliche vorteilhafte Formgebung der Grundplatte (1) dar, welche den bei Erwärmung im abgedichteten Gehäuse entstehenden Überdruck mindert, indem er eine definierte Verformung der Grundplatte (1) ermöglicht. Dies hat insbesondere den Vorteil, daß die Verformung einer (im wesentlichen) ebenen Grundplatte (1) mit der Folge des Abstoßens des Gehäuses von der Leiterplatte verhindert wird.

Anhand der Figur 3 sei das erfindungsgemäße Verfahren zum Abdichten des Gehäuses näher erläutert.

Das anhand der Figur 1 beschriebene (Relais-)Gehäuse wird mittels einer Wärmequelle (5), z. B. einer Halogenlampe, abgedichtet. Die Wärmequelle (5) erwärmt eine Kante der Gehäusekappe (2) und zwar im Bereich, in welchem die Grundplatte (1) in die Gehäusekappe (2) eingesetzt ist. Über Wärmeleitung erwärmt sich auch der Randbereich der Grundplatte (1) wobei der Heißkleberwerkstoff in diesem Bereich aufschmilzt und in Richtung auf die stärker erwärmte Gehäusekappenkante fließt.

Durch aufeinanderfolgendes Aufschmelzen aller vier Ränder wird die Verbindung zwischen Grundplatte (1) und Gehäusekappe (2) mindestens flüssigkeitsdicht abgeschlossen. Damit durch die Wärmezufuhr nur die Randbereiche aufschmelzen und nicht die gesamte Grundplatte (1) aufschmilzt, wird die Grundplatte (1) weitestgehend durch eine (in der Figur nicht dargestellte) wärmereflektierende Maske, beispielsweise aus Aluminium, abgedeckt.

Nach Aufschmelzen der Grundplattenränder ist das Gehäuse weitestgehend abgedichtet. Im Bereich der Anschlußkontakte sitzen die Anschlußstifte (3) im Preßsitz in der Grundplatte (1) aus gummielastischem Heißklebermaterial. Damit sind die Bereiche in der Grundplatte (1) um die Anschlußstifte (3) herum schon recht gut abgedichtet.

Um aber die Durchbrüche der Anschlußstifte auch gegen extrem kriechfähige Waschmedien bzw. gegen Lötlack abzudichten, ist es vorteilhaft, auch die Bereiche um die Anschlußstifte (3) durch Aufschmelzen abzudichten.

Dies geschieht auf besonders einfache und vorteilhafte Weise durch den Einlötvorgang der Anschlußstifte auf der Leiterplatte. Durch die durch das Lötbad den Anschlußstiften (3) zugeführte Wärme schmilzt die Grundplatte (1) in einem kleinen Bereich um die Anschlußstifte (3) auf. Der geschmolzene Heißkleber umschließt die Anschlußstifte (3) und führt so zu der gewünschten Abdichtung.

Sofern nicht vorgesehen ist, das Gehäuse auf eine Leiterplatte zu montieren, kann die Abdichtung der Grundplatte (1) rund um die Anschlußstifte (3) auch durch Inkontaktbringen der Anschlußstifte (3) mit einem wärmeleitenden Medium geschehen, beispielsweise durch Inkontaktbringen der Anschlußstifte (3) mit einer heißen Zange oder Eintauchen der Anschlußstifte (3) in eine heiße Flüssigkeit.

### Bezugszeichenliste:

Gehäuse zur Aufnahme von elektrischen, elektronischen oder elektromechanischen Bauteilen und Verfahren zu dessen Abdichtung
- 1: Grundplatte
- 2: Gehäusekappe
- 3: Anschlußstifte
- 4: Böckchen
- 5: Druckausgleichselement
- 6: Wärmequelle

## Patentansprüche

1. Gehäuse zur Aufnahme von elektrischen, elektronischen oder elektromechanischen Bauteilen, insbesondere Relaisgehäuse, bestehend aus einer Grundplatte (1), durch welche mehrere elektrische Anschlußstifte (3) hindurchgeführt sind, und einer Gehäusekappe (2), deren Öffnungsränder mit einem umlaufenden Rand der Grundplatte (1) verbunden sind, dadurch gekennzeichnet, daß die Grundplatte (1) aus einem Schmelzkleberwerkstoff besteht.

2. Gehäuse nach Anspruch 1, dadurch gekennzeichnet, daß der Schmelzkleberwerkstoff ein thermoplastischer Kunststoff auf Polyamid-Basis ist.

3. Gehäuse nach Anspruch 1, dadurch gekennzeichnet, daß der Schmelzkleberwerkstoff mit einem nichtthermoplastischen Material gefüllt ist.

4. Gehäuse nach Anspruch 3, dadurch gekennzeichnet, daß das Füllmaterial aus Glasfasergewebe, Glasfaservlies oder Glasfasern besteht.

5. Verfahren zur Abdichtung eines Gehäuses nach Anspruch 1, gekennzeichnet durch folgende Verfahrensschritte:
- die Anschlußstifte (3) werden in Durchbrüche der Grundplatte (1) eingesetzt oder eingepreßt,
- die Grundplatte (1) wird auf den Rand der offenen Seite der Gehäusekappe (2) aufgesetzt oder in diese eingepaßt,
- die nicht zu erwärmenden Flächen der Grundplatte (1) werden durch eine Maske abgedeckt,
- die Übergangsbereiche zwischen Grundplatte (1) und Gehäusekappe (2) werden in die Nähe einer Wärmequelle (6) gebracht und der Randbereich der Grundplatte (1) kurzzeitig aufgeschmolzen,
- die Maske wird wieder entfernt,
- nach Entfernung der Maske werden die Anschlußstifte mit Wärme beaufschlagt und die die Anschlußstifte (3) umgebenden Bereiche der Grundplatte (1) kurzzeitig aufgeschmolzen.

6. Verfahren nach Anspruch 5, dadurch gekennzeichnet, daß als Wärmequelle eine Glühlampe, insbesondere in Form eines Infrarotstrahlers oder einer Halogenlampe, Verwendung findet.

7. Verfahren nach Anspruch 5, dadurch gekennzeichnet, daß als Wärmequelle eine Heißluft erzeugende Vorrichtung verwendet wird.

8. Verfahren nach Anspruch 5, dadurch gekennzeichnet, daß als Wärmequelle (6) ein Heizelement, insbesondere ein Heizstempel, Verwendung findet.

9. Verfahren nach Anspruch 5, dadurch gekennzeichnet, daß das Abdichten der Grundplatte (1) im Bereich der Anschlußstifte (3) durch Erhitzen der Anschlußstifte (3) erfolgt.

10. Verfahren nach Anspruch 9, dadurch gekennzeichnet, daß das Erhitzen der Anschlußstifte (3) gleichzeitig beim Auflöten der Anschlußstifte (3) auf eine Leiterplatte erfolgt.

11. Verfahren nach Anspruch 9, dadurch gekennzeichnet, daß das Erhitzen der Anschlußstifte (3) durch Berühren der Anschlußstifte (3) mittels eines heißen, festen Gegenstands erfolgt.

12. Verfahren nach Anspruch 9, dadurch gekennzeichnet, daß das Erhitzen der Anschlußstifte (3) durch Eintauchen der Anschlußstifte (3) in eine heiße Flüssigkeit erfolgt.
